# EUROPEAN PATENT APPLICATION

(11) **EP 0 886 182 A1**
(43) Date of publication of application: **23.12.1998**
(21) Application number: 98110838.4
(22) Date of filing: 12.06.1998
(51) Int. Cl.: G03F 7/004, G03F 7/09

(54) **Positive photoresist composition**

(30) Priority: 16.06.1997 JP 158332/97
(71) Applicant: Sumitomo Chemical Company, Limited, Chuo-ku Osaka 541-8550 (JP)
(72) Inventor: Yako, Yuko, Takatsuki-shi, Osaka (JP); Fukui, Nobuhito, Toyonaka-shi, Osaka (JP)
(74) Representative: VOSSIUS & PARTNER

(57) **Abstract**

A chemical amplifying type positive photoresist composition, excellent in various properties, particularly in TDE resistance as well as sensitivity and resolution, and able to suppress unfavorable halation effect without deteriorating profile, which comprises (A) a resin which is converted to alkali-soluble from alkali-insoluble or only slightly alkali soluble by the action of an acid, (B) an acid generator, (C) a basic compound and (D) a fluorenone compound represented by the following formula (I): 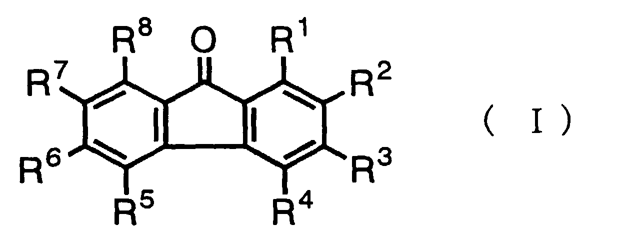 wherein R¹, R², R³, R⁴, R⁵, R⁶, R⁷ and R⁸ each independently represent hydrogen, alkyl having 1 to 6 carbon atoms which may be optionally substituted with halogen, halogen or nitro is provided; and a precise fine photoresist pattern can be formed in high precision using the photoresist composition.

## Description

The present invention relates to a photoresist composition suitable for lithography utilizing high-energy radiation such as a far ultraviolet ray including eximer laser, electron beam or X-rays.

Recently, with development of higher integration of an integrated circuit, formation of a submicron pattern is required. Eximer laser lithography has attracted special interest for such a requirement, particularly for it enables production of 64 MDRAM and 256 MDRAM. As a resist suitable for such eximer laser lithography process, a so-called chemical amplifying type resist has been suggested which utilizes an acid catalyst and chemical amplifying effect. In the chemical amplifying type resist, solubility of the portion irradiated with a radiation in an alkaline developer is changed through a reaction utilizing an acid catalyst generated from an acid generator in the irradiated portion, and by this, a positive or negative pattern is obtained.

In the chemical amplifying type positive resist, an acid generated in the irradiated portion diffuses by post heat treatment (post exposure bake: hereinafter, abbreviated as PEB), and acts as a catalyst for changing solubility of the irradiated portion in a developer. However, such a chemical amplifying type resist has a defect that performances thereof change due to deactivation of the acid generated in the resist by a small amount of ammonia or amines existing in surrounding atmosphere during the standing time from irradiation to PEB. This effect is known. as time delay effect.

For suppressing the time delay effect, namely to promote time delay effect resistance (hereinafter, referred to as TDE resistance), it is known that adding a basic compound, such as amines, as a quencher to a chemical amplifying type positive resist is effective.

Such a chemical amplifying type resist has another defect that the acid generator is liable to be decomposed by the reflected light from the substrate. For example, when the irradiated light is reflected to a lateral direction due to a difference in level on the substrate, the reflected light of a lateral direction causes so-called halation effect, which makes the line width of a part of the pattern narrower and makes it difficult to obtain a defined line width of the pattern.

For suppressing the halation effect, a dye having an absorption at the wave length of the radiation used for the irradiation is generally added to the resist to lower transmittance of the resist film and to suppress interference of the light in the film. However, there is a defect that, if conventional dye is used for suppressing the halation effect, the profile of the resist pattern is conspicuously deteriorated.

The object of the present invention is to provide a chemical amplifying type positive photoresist composition excellent in various properties such as resolution, sensitivity, film retention ratio, applicability, heat resistance and TDE resistance, as well as capable in suppressing the halation effect and in giving a good profile. This object could be achieved on the basis of the finding that a positive photoresist composition having excellent performances is obtained by compounding a specific compound in the resist composition.

The present invention provides a positive photoresist composition comprising (A) a resin which is converted to alkali-soluble from alkali-insoluble or only slightly alkali soluble by the action of an acid, (B) an acid generator, (C) a basic compound and (D) a fluorenone compound represented by the following formula (I): 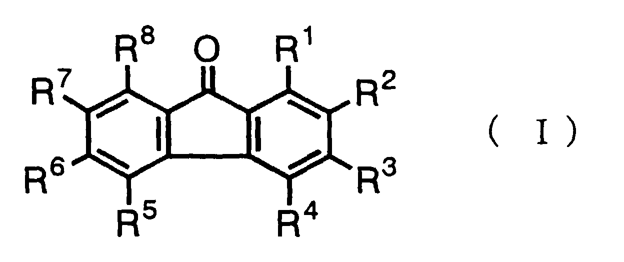 wherein R¹, R², R³, R⁴, R⁵, R⁶, R⁷ and R⁸ each independently represent hydrogen, alkyl having 1 to 6 carbon atoms which may be optionally substituted with halogen, halogen or nitro.

The resin (A) which is a main component of the photoresist component is by itself alkali-insoluble or only slightly alkali soluble, and becomes alkali soluble by a chemical reaction caused by the action of an acid. For example, there is used a resin obtained by protecting at least a part of a phenolic hydroxyl group in an alkali soluble resin having a phenol skeleton with a group which has solution inhibiting ability against alkaline developers and is unstable against acid.

Examples of the alkali soluble resin used for producing the resin (A) include novolak resins, polyvinylphenol resins, polyisopropenylphenol resins, copolymers of vinylphenol with styrene, acrylonitrile, methyl methacrylate or methyl acrylate, and copolymers of isopropenylphenol with styrene, acrylonitrile, methyl methacrylate or methyl acrylate. Positional relation between a hydroxy group and a vinyl group or an isopropenyl group in vinylphenol and isopropenylphenol is not particularly limited, however, in general, p-vinylphenol or p-isopropenylphenol is preferred. Hydrogen may also be added to these resins for improving transparency. An alkyl group, alkoxy group and the like may be introduced into a phenol nucleus of the above-described resins, as long as the resulting resin is alkali-soluble. Among these alkali soluble resins, polyvinylphenol-based resins, namely a homopolymer of vinylphenol or copolymer of vinylphenol with other monomer are preferably used.

The group to be introduced in the alkali soluble resin which has solution inhibiting ability against an alkali developer and is unstable against acid can be selected from various known protecting groups. Examples thereof include a tert-butoxycarbonyl group, tert-butoxycarbonylmethyl group, tetrahydro-2-pyranyl group, tetrahydro-2-furyl group, methoxymethyl group and 1-ethoxyethyl group. These groups shall be substituted for hydrogen on a phenolic hydroxyl group. Among these protecting groups, particularly, 1-ethoxyethyl group is preferred. The ratio of the phenolic hydroxyl groups substituted by the protecting group to the all phenolic hydroxyl groups in the alkali soluble resin (protective group introducing ratio) is preferably from 10 to 50%, in general.

It is preferred that the resin (A) comprises a resin obtained by protecting a phenolic hydroxyl group in the above-described polyvinylphenol-based resin with a group which has solution inhibiting ability against an alkali developer and is insecure against acid. Among them, particularly preferred is a resin obtained by partially protecting a phenolic hydroxyl group in the polyvinylphenol-based resin with a 1-ethoxyethyl group.

The acid generator (B) can be selected from various compounds which generate an acid by irradiation to the substance itself or a resist composition containing the substance. The acid generator (B) can be used as a mixture of two or more compounds. Examples thereof include onium salts, organic halogen compounds, compounds having a diazomethanedisulfonyl skeleton, disulfone compounds having an aromatic group, orthoquinone diazide compounds and sulfonic acid compounds. In the present invention, as the acid-generator, compounds having a diazomethanedisulfonyl skeleton are preferably used. Examples of the compounds having a diazomethanedisulfonyl skeleton as the acid generator include bis(benzenesulfonyl)diazomethane, bis(4-chlorobenzenesulfonyl)diazomethane, bis(p-toluenesulfonyl)diazomethane, bis(4-tert-butylbenzenesulfonyl)diazomethane, bis(2,4-xylenesulfonyl)diazomethane and bis(cyclohexanesulfonyl)diazomethane.

The basic compound (C) is an organic compound which works as a quencher for improving TDE resistance. It is preferable that the basic compound (C) is a compound which does not vaporize at pre-baking temperature, so that it remains in a resist film formed on a substrate even after pre-baking of the resist film and exhibits its effect. Therefore, in general, a compound having the boiling point of 150°C or higher is used as the tertiary amine compound (C). The basic compound (C) can be an organic compound having a primary, secondly or tertiary amine compound, and among them, tertiary amine compound is preferably used in the present invention. Examples of the basic compound (C) include N-methyl-di-n-octylamine, N-methyl-dicyclohexylamine, N-phenyl-diethanolamine, 2-diethylaminoethanol, N-methylmorpholine, N-ethylmorpholine, N-(2-hydroxyethyl)morpholine, 1-(2-hydroxyethyl)pyrrolidine, 2-N-ethylanilinoethanol and tris[2-(2-methoxyethoxy)ethyl]amine.

In addition to the above-described resin (A), the acid generator (B) and the basic compound (C), the photoresist composition of the present invention comprises (D) a fluorenone compound represented by the formula (I). In the formula (I), R¹, R², R³, R⁴, R⁵, R⁶, R⁷ and R⁸ each independently represent hydrogen, alkyl having 1 to 6 carbon atoms, alkyl having 1 to 6 carbon atoms which is substituted with halogen, halogen or nitro. Examples of the alkyl having 1 to 6 carbon atoms include methyl, ethyl, propyl, isopropyl, butyl, sec-butyl, tert-butyl, pentyl and hexyl One or more of the hydrogen atoms of the alkyl may be optionally substituted with halogen. Examples of the halogen as the substituent on the alkyl include fluorine, chlorine and bromine. By incorporating the fluorenone compound of formula (I) in the resist composition, halation can be suppressed without deteriorating profile.

Examples of the fluorenone compound (D) include 9-fluorenone, 1-methyl-9-fluorenone, 2-methyl-9-fluorenone, 3-methyl-9-fluorenone, 4-methyl-9-fluorenone, 1-ethyl-9-fluorenone, 2-ethyl-9-fluorenone, 3-ethyl-9-fluorenone, 4-ethyl-9-fluorenone, 1-butyl-9-fluorenone, 2-butyl-9-fluorenone, 3-butyl-9-fluorenone, 4-butyl-9-fluorenone, 1,2-dimethyl-9-fluorenone, 1,3-dimethyl-9-fluorenone, 1,7-dimethyl-9-fluorenone, 3,6-dimethyl-9-fluorenone, 2,7-di-tert-butyl-9-fluorenone, 4-trifluoromethyl-9-fluorenone, 1-fluoro-9-fluorenone, 2-fluoro-9-fluorenone, 3-fluoro-9-fluorenone, 4-fluoro-9-fluorenone, 1-chloro-9-fluorenone, 2-chloro-9-fluorenone, 3-chloro-9-fluorenone, 4-chloro-9-fluorenone, 1-bromo-9-fluorenone, 2-bromo-9-fluorenone, 3-bromo-9-fluorenone, 4-bromo-9-fluorenone, 3-nitro-9-fluorenone, 2,7-dinitro-9-fluorenone, 2,4,7-trinitro-9-fluorenone and 1-methyl-4-nitro-9-fluorenone.

The amount of the resin (A) is preferably from 20 to 99% by weight, more preferably from 50 to 99% by weight, based on the weight of total solid component of this composition. The amount of the acid-generator (B) is preferably from 0.05 to 20% by weight, more preferably from 0.05 to 15% by weight, based on the weight of total solid component of this composition. The amount of the basic compound (C) is preferably from 0.001 to 10% by weight, more preferably from 0.001 to 3% by weight, based on the weight of total solid component of this composition. The amount of the fluorenone compound (D) is preferably from 0.01 to 20% by weight, more preferably from 0.01 to 10 % by weight, based on the weight of total solid component of this composition.

The photoresist composition of the present invention may optionally comprise other components, for example, various additives conventionally used in this field such as a dissolution inhibitor, sensitizer, dye in addition to the fluorenone compound (D), adhesion improver and electron donor.

A resist solution is prepared by mixing the above respective components with a solvent so that the concentration of the total solid content in this positive photoresist composition is within the range from 10 to 50% by weight. The solution is coated on a substrate such as silicon wafer. The solvent used may be any one which can dissolve the respective components and may be those which are normally used in this field. Examples thereof include glycol ether esters such as ethylcellosolve acetate, methylcellosolve acetate, propylene glycol monomethyl ether acetate and propylene glycol monoethyl ether acetate, glycol mono or diethers such as ethylcellosolve, methylcellosolve, propylene glycol monometyl ether, propylene glycol monoethyl ether and diethylene glycol dimethyl ether, esters such as ethyl lactate, butyl lactate and ethyl pyruvate, ketones such as 2-heptanone, cyclohexanone and methyl isobutyl ketone, and aromatic hydrocarbons such as xylene. These solvents may be used alone or in combination of two or more.

A positive pattern is formed from the resist film coated on a substrate, usually via respective processes such as pre-baking, patterning exposure, PEB, developing with an alkali developer.

The following example further illustrates the present invention in detail, but does not limit the scope thereof. In example, reference example and comparative example, all "part" or "parts" is by weight unless otherwise stated.

### Reference Example (protection of resin)

Into a nitrogen-purged 500 ml four-necked flask were charged 25 g (208 mmol in terms of p-vinylphenol unit) of poly(p-vinylphenol) having a weight average molecular weight (Mw) of 23,900 and a polydispersion (Mw/Mn) of 1.12 [VP-15000 manufactured by Nippon Soda Co., Ltd.) and 0.021 g(0.109 mmol) of p-toluenesulfonic acid, and they were dissolved in 250 g of 1,4-dioxane. To this solution was added dropwise 7.88 g (109 mmol) of ethylvinyl ether, then, the mixture was reacted at 25°C for 5 hours. Thereafter, the reaction solution was added dropwise into 1500 ml of ion-exchanged water, then filtered to obtain a white wet cake. This wet cake was again dissolved into 200 g of 1,4-dioxane, then the solution was added dropwise to 1500 ml of ion-exchanged water, and filtered. The resulted wet cake was washed by stirring in 600 g of ion-exchanged water, and filtered to take a wet cake. Thereafter, this washing operation using this ion-exchanged water was repeated twice. The resulted white wet cake was dried under reduced pressure to obtain a resin in which a hydroxyl group of poly(p-vinylphenol) was partially 1-ethoxyethyl etherified. This resin was analyzed by ¹H-NMR to find that 35% of the hydroxy group was protected by a 1-ethoxyethyl group. This resin had a weight average molecular weight of 31,200 and a polydispersion of 1.17.

### Example 1

13.5 Parts of the resin synthesized in Reference Example, 0.5 part of bis(cyclohexanesulfonyl)diazomethane as an acid generator, 0.015 part of N-methyl-dicyclohexylamine as a quencher and 0.2 part of 9-fluorenone were dissolved in 67 parts of propylene glycol monomethyl ether acetate. The resulted solution was filtered through a filter made of a fluorine resin having a pour size of 0.1 µm to prepare a resist solution.

On a silicone wafer washed by a conventional method, the resist solution thus obtained was coated using a spin coater so that the thickness after drying was 0.7 µm. Then, this silicone wafer was pre-baked at 90°C for 90 seconds on a hot plate. The film after the pre-baking was subjected to exposure treatment using KrF eximer laser stepper having an exposure wavelength of 248 nm [NSR-1755 EX8A manufactured by Nikon Corp., NA = 0.45) with changing exposure amount stepwise, through a chromium mask having a pattern. The wafer immediately after the exposure was heated for 90 seconds at 90°C on a hot plate for conducting PEB to effect de-protective group reaction in the exposed portion. This was developed with 2.38% by weight aqueous solution of tetramethylaminium hydroxide to obtain a positive pattern.

The pattern thus formed was observed by an electron microscope. A fine pattern of 0.23 µm was resolved in good profile at an exposure of 72 mJ/cm². Transmittance of the resist film of 0.7 µm thickness was 45 % at a wave length of 248 nm.

### Example 2

The same procedure as in Example 1 was conducted except that N-methyl-dicyclohexylamine was replaced with tris[2-(2-methoxyethoxy)ethyl]amine and amount of 9-fluorenone was changed from 0.2 part to 0.34 part. As a result, a fine pattern of 0.22 µm was resolved in good profile at an exposure of 73 mJ/cm².

### Comparative Example

The same procedure as in Example 1 was conducted except that 9-fluorenone was replaced with benzophenoe. As a result, although a fine pattern of 0.23 µm was resolved at an exposure of 91 mJ/cm², loss of thickness was conspicuously big and the resolution was only 0.30 µm.

The photoresist composition according to the present invention which comprises a basic compound as well as a specific fluorenone compound is excellent in TDE resistance as well as sensitivity and resolution. It suppresses unfavorable halation effect without deteriorating profile. Accordingly, using the resist composition of the present invention allows to obtain a fine photoresist pattern in high precision.

## Claims

1. A positive photoresist composition comprising (A) a resin which is converted to alkali-soluble from alkali-insoluble or only slightly alkali soluble by the action of an acid, (B) an acid generator, (C) a basic compound and (D) a fluorenone compound represented by the following formula (I): 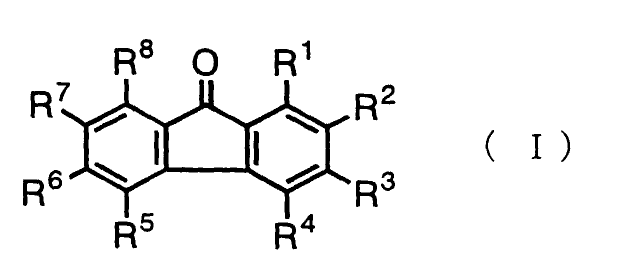 wherein R¹, R², R³, R⁴, R⁵, R⁶, R⁷ and R⁸ each independently represent hydrogen, alkyl having 1 to 6 carbon atoms which may be optionally substituted with halogen, halogen or nitro.

2. The composition according to Claim 1, wherein the resin (A) contains a resin obtained by partially protecting a phenolic hydroxyl group in a polyvinylphenol resin with a 1-ethoxyethyl group.

3. The composition according to Claim 1, wherein the acid generator (B) is a diazomethanedisulfonyl compound.

4. The composition according to Claim 1, wherein the basic compound (C) is a tertiary amine compound.

5. The composition according to Claim 1, wherein the fluorenone compound (D) is 9-fluorenone.

6. The composition according to Claim 1, wherein the amount of the resin (A) is from 20 to 99% by weight, the amount of the acid-generator (B) is from 0.05 to 20% by weight, the amount of the basic compound (C) is from 0.001 to 10% by weight and the amount of the fluorenone compound (D) is from 0.1 to 20% by weight.
